# FASCICULE DE BREVET EUROPEEN

(11) **EP 0 413 617 B1**
(45) Date de publication et mention de la délivrance du brevet: **29.03.1995**
(21) Numéro de dépôt: 90402153.2
(22) Date de dépôt: 26.07.1990
(51) Int. Cl.: C03C 17/38, C23C 16/50

(54) **Procédé de dépôt de couches minces**
Verfahren zur Abscheidung von Dünnschichten
Method for depositing thin layers

(30) Priorité: 14.08.1989 FR 8910870
(43) Date de publication de la demande: 20.02.1991
(73) Titulaire: SAINT GOBAIN VITRAGE INTERNATIONAL, 92400 Courbevoie (FR)
(72) Inventeur: Balian, Pierre, F-75015 Paris (FR); Rousseau, Jean-Paul, F-92100 Boulogne (FR)
(74) Mandataire: Muller, René

(56) Documents cités:
- EP-A- 0 154 814
- EP-A- 0 230 188

## Description

L'invention concerne un procédé et un dispositif pour déposer une couche mince par une technique de plasma-CVD sur un substrat conducteur du courant électrique et plus particulièrement sur un substrat isolant préalablement rendu conducteur par le dépôt d'une couche mince conductrice ainsi que le produit obtenu.

Il est connu de protéger les surfaces de différents matériaux en y déposant une couche mince d'un composé organique obtenu par réaction chimique sous plasma à pression réduite à partir d'un monomère. Ainsi, la demande de brevet européen EP 230 188 décrit un film organo-silicié obtenu par l'introduction sous vide primaire d'un monomère organo-silicié sous forme gazeuse dans une décharge électrique créée par couplage capacitif entre deux électrodes disposées à faible distance l'une de l'autre, l'une étant reliée à la masse et supportant le substrat à revêtir, l'autre, située à faible distance étant reliée à un générateur de puissance fonctionnant à des fréquences inférieures à un mégaherz. Ce procédé permet d'obtenir des couches minces qui ont de nombreuses applications en particulier comme protection des couches minces à base d'argent déposées sur le verre.

Dans le procédé précédent, le substrat reste immobile pendant le dépôt mais on connaît également d'autres procédés où d'une part le plasma est confiné à l'aide d'un champ magnétique et où d'autre part le substrat se déplace par rapport aux électrodes et donc, par rapport au plasma.

Un tel procédé est lourd à mettre en oeuvre car il nécessite un système mécanique d'entraînement sous vide, il est donc difficile de réalisation et d'entretien. Par ailleurs, on a vu que les couches minces organo-silicées étaient destinées le plus souvent à protéger des couches fonctionnelles plus fragiles. Sur une ligne de production industrielle, sur laquelle on effectue le dépôt des premières couches sur le verre - dont celle à base d'argent évoquée plus haut - il faudrait disposer d'une chambre spéciale analogue à celles où s'effectuent les dépôts des premières couches et placée entre elles et le sas de sortie, où normalement la pression est ramenée à la pression atmosphérique, on effectuerait alors dans cette chambre le dépôt de l'ultime couche de protection.

En revanche le premier procédé évoqué, permet, dans certaines limites, d'effectuer le dépôt sans déplacement relatif entre le verre et le plasma où sont créés les radicaux et les ions qui se recombinent ensuite pour former la couche polymérisée, il est donc possible d'effectuer le dépôt sur le verre immobile, par exemple pendant son arrêt dans le sas d'entrée ou le sas de sortie d'une ligne industrielle de pulvérisation cathodique.

Cependant ce procédé a ses limites. On constate en particulier que la zone dans laquelle s'effectue la majeure partie du dépôt de polymère est celle proche de l'électrode placée au-dessus du verre et le dépôt s'effectue aussi vite sur celle-ci que sur le verre à traiter. Ceci a des conséquences multiples, tout d'abord le rendement quantitatif du procédé n'est pas bon, on ne retrouve dans le polymère sur le verre qu'une faible part des quantités de monomères introduites dans l'enceinte. Mais le fonctionnement du procédé lui-même est gêné par ce dépôt préférentiel sur l'électrode supérieure : le dépôt qui est isolant modifie les caractéristiques du champ électrique créé sous l'électrode, on constate une dérive qu'il faut corriger en agissant sur les paramètres électriques du procédé. Mais par ailleurs, un effet mécanique néfaste peut également se manifester : le dépôt sur l'électrode voit son épaisseur croître régulièrement dans le temps lorsqu'on traite successivement plusieurs feuilles de verre à la suite l'une de l'autre. Cette couche en s'épaississant devient friable et finit par se déliter, des copeaux tombent alors sur le substrat où ils perturbent le dépôt. Par ailleurs la vitesse de dépôt sur le verre n'est pas très grande et l'on constate des effets de bord, c'est-à-dire que l'épaisseur de la couche finale est plus grande au centre qu'en face des bords de l'électrode.

La présente invention se donne pour tâche de remédier à ces divers inconvénients.

L'invention propose un procédé de dépôt d'une couche mince par plasma-CVD sur un substrat conducteur dans lequel c'est le substrat qui sert d'électrode pour créer la décharge. Ce substrat est en matériau isolant recouvert d'une couche mince conductrice. Le dépôt s'effectue jusqu'à 180 cm de l'amenée de courant et de manière préférentielle jusqu'à environ 160 cm. De plus, la fréquence est avantageusement comprise entre 10 et 400 kHz. Lorsque le dépôt est celui d'un composé organo-silicié, il se fait en présence d'oxygène apporté par le protoxyde d'azote.

L'invention concerne également un substrat en verre recouvert de couches minces parmi lesquelles figure au moins une couche de métal, notamment d'argent et sur lequel la couche organo-siliciée est déposée selon le procédé.

La description et les figures permettront de comprendre le fonctionnement de l'invention et ses avantages.
La figure 1 représente une vue schématique d'une installation où le procédé peut être mis en oeuvre,
La figure 2 représente l'amenée de courant qui permet la mise sous tension du substrat conducteur,
La figure 3, elle, montre les conditions expérimentales qui permettent de réaliser le dépôt à une grande distance de l'amenée de courant de la figure 2.

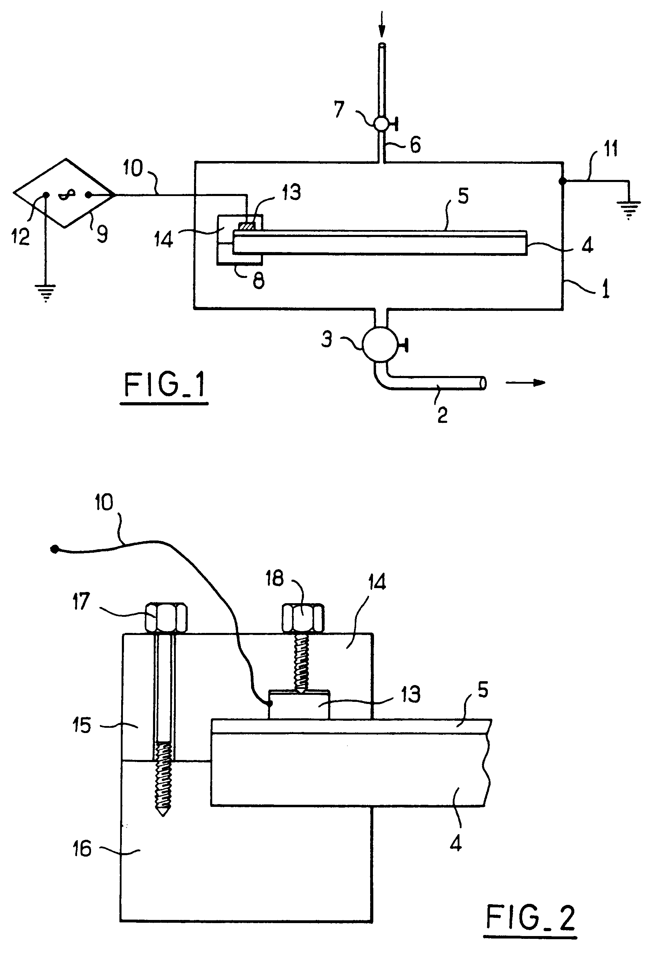

La méthode de dépôt selon l'invention peut se mettre en oeuvre sur n'importe quelle installation sous vide. Elle ne nécessite en particulier aucun déplacement de l'échantillon ni d'aucune partie mobile dans l'installation lorsque le vide est réalisé. La figure 1 schématise l'installation. L'enceinte à vide 1 est évacuée grâce à la canalisation 2 reliée à un système de pompage primaire et/ou secondaire traditionnel non représenté. Une vanne 3 permet de séparer l'installation des pompes, en particulier lorsqu'on veut mettre l'intérieur de l'enceinte en communication avec l'atmosphère ambiante. Dans l'exemple présenté, l'échantillon de verre 4 est recouvert d'une couche conductrice 5, c'est par exemple une couche d'argent d'une épaisseur de 10 nm déposée entre deux couches d'oxyde d'étain SnO₂ chacune d'une épaisseur de 40 nm. Ce sont ces couches, relativement sensibles aux influences extérieures qu'il s'agit de protéger par le dépôt d'une couche d'un composé organo-silicié polymérisé. En effet l'argent est un métal fragile mécaniquement et chimiquement et lorsque l'on veut réaliser un vitrage isolant dont une des face internes possède une telle couche à base d'argent et qu'on souhaite de plus pouvoir effectuer cette transformation indépendamment de la production du verre à couche lui-même, c'est-à-dire en un lieu distinct et à une époque plus tardive, on est obligé de prendre des précautions de stockage et d'exploitation draconiennes telles que stockage en milieu sec, machines à laver spéciales, etc... C'est pour diminuer la rigueur de ces mesures qu'on veut disposer d'une couche protectrice incolore. Celle-ci doit posséder un ensemble de propriétés difficiles à réunir, puisqu'il faut qu'en plus d'être invisible elle joue son rôle de protection mécanique et chimique mais il faut néanmoins que son épaisseur reste suffisamment faible pour ne pas modifier les propriétés infra-rouges de la couche sous-jacente et particulièrement sa faible émissivité. Une couche du type de celle décrite dans la demande de brevet européen EP 230 188 rassemble ces caractéristiques. Comme dans la méthode décrite dans cette demande antérieure, on introduit dans le procédé de l'invention, un mélange d'un gaz plasmagène et d'un monomère organo-silicié comme par exemple l'hexaméthyldisiloxane (HMDSO) ou l'hexaméthyldisilazane (HMDS) et en général les alkylsilazanes, le vinyltriméthoxysilane (VTMOS) le vinyldiméthyléthoxysilane (VDMEOS), le diméthyldiéthoxysilane (DMDEOS), le triméthyléthoxysilane (TMEOS), le tétraméthoxysilane (TMOS), le tétraéthoxysilane (TEOS) et en général les alkoxysilanes. Tous ces gaz conduisent à l'obtention de couches à base de silice. Mais le procédé est également valable pour d'autres gaz permettant l'obtention d'autres couches comme par exemple le méthane produisant une couche carbonée ou un gaz organométallique conduisant à une couche dont le composant essentiel est l'oxyde du métal concerné. L'introduction du gaz s'effectue par la canalisation 6, elle est gérée par la vanne 7 commandée par un système de gestion de gaz non représenté.

La proportion de monomère dans le gaz plasmagène dépend de leurs natures respectives et des conditions du dépôt, les conditions de l'exemple suivant fournissent de bons résultats.

Dans une installation de laboratoire où l'enceinte est un cylindre d'axe vertical d'une hauteur de 35 cm et d'un diamètre de 60 cm, l'échantillon est constitué par une glace plane d'épaisseur 4 mm faite d'un verre silico-sodocalcique de dimensions 30 x 30 cm. Cette glace est recouverte d'une couche triple comportant une sous-couche diélectrique SnO₂ d'une épaisseur de 40 nm déposée par pulvérisation cathodique réactive à partir d'une cible d'étain, d'une couche "active" d'argent d'épaisseur 10 nm déposée par la même méthode en atmosphère d'argon et d'une troisième couche diélectrique analogue à la première. Cette plaque est placée à mi-hauteur de l'enceinte, couche vers le haut. Elle repose sur un support dont la nature importe peu.

Le dispositif de l'invention comporte une amenée de courant 8 qui permet de relier le substrat conducteur - ou rendu conducteur comme dans le cas de l'exemple - à une source de tension alternative 9 par l'intermédiaire d'un câble adapté 10. L'enceinte elle-même est reliée à la masse par un câble 11 de même que l'autre pôle 12 de la source de courant alternatif 9.

L'amenée de courant proprement dite est placée sur le bord et toute la longueur de la plaque 4. Elle comporte un élément conducteur 13 - en cuivre dans l'exemple - noyé dans un matériau isolant 14.

La figure 2 montre une vue de détail d'un mode particulier de réalisation de l'amenée de courant 8. Le conducteur de cuivre 13 est en contact avec la couche 5 sur tout le long du bord de la plaque 4. Mais ce conducteur en métal 13 est entièrement recouvert par le matériau isolant 14. Celui-ci, du PTFE dans l'exemple, constitue les deux parties 15 et 16 du support de l'amenée de courant, elles sont reliées et serrées sur le verre par des vis telles que 17. L'amenée de courant proprement dite 13, en cuivre dans l'exemple est pressée elle aussi sur le verre grâce à une série de vis isolantes 18. Elle est reliée, par l'intermédiaire du câble 10 à la source de courant alternatif 9.

La technique de dépôt nécessite de disposer d'un substrat particulièrement propre. Cela peut résulter ou bien d'un nettoyage soigné ou bien du fait que le dépôt s'effectue immédiatement à la suite du dépôt des couches sous-jacentes, sans retour à l'atmosphère. Dans le premier cas, c'est-à-dire, si les deux phases de production sont séparées, le nettoyage se termine avantageusement par un effluvage. Dans l'exemple cité, après avoir effectué un vide de O,013 hPa, on introduit de l'argon et on laisse la pression s'établir à 0,40 hPa puis on crée une effluve à l'aide d'un courant alternatif qu'on établit entre la surface conductrice du substrat et l'enceinte à une fréquence de 100 kHz et une puissance de 100 watts dans l'exemple retenu. Après 30 secondes, le courant est coupé.

Pour réaliser le dépôt on introduit alors le gaz monomère qui est véhiculé par le gaz plasmagène.

Dans l'exemple, le gaz plasmagène était du protoxyde d'azote N₂O, il apporte l'oxygène nécessaire à la réaction. Des essais avec un mélange argon-oxygène ont également donné pleine satisfaction. Le gaz organosilicié était dans l'expérience, de l'hexamétyldisiloxane (HMDSO) dans une proportion de 10 %. Après que la pression se soit stabilisée à 0,15 hPa, on introduit le mélange avec un débit de 200 cm³/mn (conditions normales de température et de pression, CNTP.

Dès que les conditions débit-pression se sont stabilisées, on allume le plasma en mettant le conducteur 13 sous tension alternative. Dans l'exemple choisi, la fréquence était de 100 kHz et les meilleurs résultats ont été obtenus avec une puissance de 300 watts pour une longueur d'amenée de courant de 30 cm. Des essais ont montré que, d'une manière générale, les conditions de dépôt sont comparables si la puissance varie proportionnellement à la longueur de l'amenée de courant. Dans le cas de l'exemple, on obtient en 8 secondes une couche homogène et régulière d'une épaisseur de 30 nm.

En observant l'aspect du plasma au moment du dépôt, on constate que l'endroit où il est le plus lumineux est à la surface du substrat utilisée comme électrode : c'est là l'endroit où la densité des espèces plus ou moins dissociées créées dans le plasma est la plus grande. On voit là la raison pour laquelle la couche obtenue adhère particulièrement bien au substrat et également pourquoi sa vitesse de croissance est grande : l'énergie cinétique des espèces créées est importante et d'autre part, la probabilité de rencontre d'espèces entre-elles et d'espèces avec la couche en cours de formation est également élevée. La couche obtenue dans ces conditions est très différente de ce qu'elle est avec un dispositif classique qui utilise deux électrodes comme celui de la demande de brevet EP 230 188 par exemple.

Une des questions qu'on peut se poser concerne la limite du procédé et plus précisément, jusqu'à quelle distance de l'amenée de courant 13, le plasma est suffisamment intense pour que la dissociation du monomère du composé organo-silicié soit suffisante, pour qu'il se crée suffisamment d'espèces actives pour qu'on puisse constater leur recombinaison sous forme polymérisée sur le substrat.

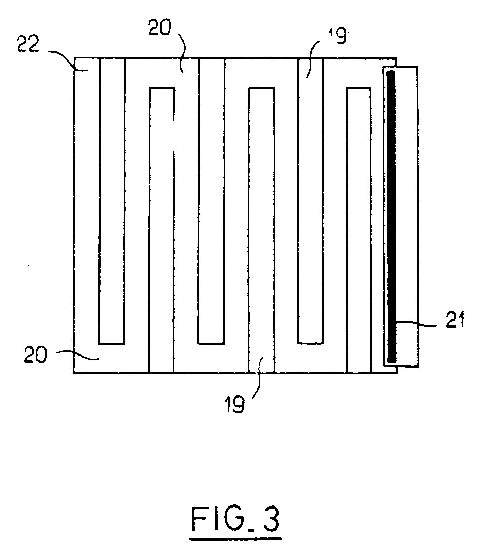

On a donc réalisé un échantillon particulier. Il s'agit d'une plaque de verre de 30 x 30 cm sur laquelle avait été déposée la même combinaison de couches argent et diélectriques que précédemment. Mais sur certaines zones, marquées 19 sur la figure 3, on a procédé à l'aide d'une meule à l'abrasion totale de la couche. Les zones restantes 20 constituent un labyrinthe par lequel le courant alternatif doit passer depuis l'amenée de courant 21 qui s'étend sur toute la largeur de l'échantillon jusqu'au coin le plus éloigné 22. Si l'on observe le plasma luminescent pendant le dépôt, on constate d'une part qu'il est localisé exclusivement au-dessus des zones 20 où la couche conductrice est présente et que les zones 19 restent obscures et d'autre part que la luminosité très forte auprès de l'amenée de courant 21 décroît rapidement sur une dizaine de centimètres pour rester apparemment constante jusqu'au point le plus éloigné 22.

A la fin du dépôt qui s'effectue dans les mêmes conditions que dans l'exemple précédent, on constate que le dépôt s'est produit tout au long de la piste 20 jusques et y compris dans la zone la plus éloignée 22. Son épaisseur est régulière, on a mesuré 20 ± 2 nm. Ces variations d'épaisseur sont pratiquement indécelables à l'oeil. On constate ainsi que le procédé permet d'obtenir des dépôts de qualité jusqu'à des distances importantes de l'ordre de 180 cm au moins. Si l'on utilise deux amenées de courant, chacune sur l'un des deux côtés opposés d'un substrat en verre float revêtu d'une couche conductrice, la technique permet de déposer une couche par plasma-CVD sur un plateau de largeur industrielle comme ceux de 3,20 m ou 4,OO m qu'on rencontre habituellement.

Ce qui précède montre que le procédé de l'invention fournit une technique très intéressante pour fabriquer des couches, en particulier, des couches organo-siliciées minces de bonne qualité sur des substrats conducteurs ou rendus conducteurs grâce au dépôt préalable de couches conductrices, technique compatible avec la production industrielle de plateaux de verre à couche de grande dimension en particulier en sous-couche déposée sur un verre déjà équipé d'une couche conductrice par exemple pyrolysée ou en sur-couche, avant ou après le dépôt de couches diélectriques et/ou métalliques par pulvérisation cathodique. Cette opération s'effectue alors de préférence dans le sas d'entrée ou de sortie d'une ligne de production industrielle.

## Revendications

1. Procédé de dépôt dans une enceinte à vide (1) d'une couche mince par plasma-CVD sur un substrat conducteur qui sert d'électrode pour créer la décharge, **caractérisé en ce que** le substrat (4) est en matériau isolant sous forme de plaque ou de feuille recouvert d'une couche mince conductrice (5) et **en ce qu'**on établit le courant alternatif provoquant ladite décharge entre la couche mince conductrice (5), par au moins une amenée de courant (13 ; 21) appropriée, et l'enceinte à vide (1).

2. Procédé selon la revendication 1, **caractérisé en ce que** la distance qui sépare un point quelconque où s'effectue le dépôt de l'amenée de courant la plus proche est inférieure à ou de l'ordre de 180 cm, notamment d'environ 160 cm.

3. Procédé selon l'une des revendications précédentes, **caractérisé en ce que** le courant alternatif provoquant la décharge est amené sur au moins un des côtés du substrat conducteur (4, 5).

4. Procédé selon la revendication 3, **caractérisé en ce que** le courant alternatif provoquant la décharge est amené sur les deux côtés opposés des substrats conducteurs (4, 5).

5. Procédé selon l'une des revendications précédentes, **caractérisé en ce que** la fréquence du courant est inférieure à 1 MHz, notamment comprise entre 10 et 400 kHz.

6. Procédé selon l'une des revendications précédentes, **caractérisé en ce que** la couche déposée par CVD-plasma est une couche organo-siliciée.

7. Procédé selon la revendication 6, **caractérisé en ce que** le dépôt se fait en présence d'oxygène.

8. Procédé selon la revendication 7, **caractérisé en ce que** l'oxygène est apporté par le protoxyde d'azote.

9. Procédé selon l'une des revendications précédentes, **caractérisé en ce que** le gaz réactif est amené au travers de l'enceinte à vide (1) qui est l'électrode non constituée par le substrat conducteur (4, 5).

10. Dispositif de mise en oeuvre du procédé selon l'une des revendications précédentes, **caractérisé en ce** **qu'**il comporte une enceinte à vide (1), au moins une amenée de courant métallique (13 ; 21) destinée à être en contact étroit avec le substrat conducteur (4, 5) à à recouvrir et une source de tension alternative (9), ladite source établissant le courant alternatif nécessaire à la décharge entre le substrat conducteur (4, 5) et l'enceinte à vide (1) en alimentant ledit substrat par la (ou les) amenées(s) de courant (13 ; 21).

11. Dispositif selon la revendication 10, **caractérisé en ce que** la (les) amenée(s) de courant (13 ; 21) est (sont) disposée (s) sur au moins un des bords du substrat conducteur (4, 5), la ou (les) amenée(s) étant, à l'exception de leur surface de contact avec le substrat conducteur (4, 5) entièrement inclue (s) dans un matériau isolant (14).

12. Dispositif selon la revendication 10 ou 11, **caractérisé en ce qu**'il comporte une ou plusieurs arrivées (6) de gaz réactif dans l'enceinte à vide (1).

13. Substrat en matériau isolant (4), notamment en verre, revêtu d'une couche conductrice, notamment en verre revêtu de couches minces dont l'une au moins (5) est conductrice, telle qu'en métal, notamment l'argent, comprenant en outre un revêtement du type revêtement organo-silicié, déposé par une technique de plasma-CVD, **caractérisé en ce que,** sur une largeur d'au moins 3,60 m, la variation d'épaisseur de ladite couche de revêtement n'est pas supérieure à 10 %.

14. Substrat en matériau isolant (4) notamment en verre selon la revendication 13, **caractérisé en ce que** les couches minces comprennent une couche de diélectrique tel SnO₂ directement au contact du substrat (4), puis une couche de métal tel Ag (5), puis éventuellement une couche d'Al ou d'un métal appartenant au groupe Al, Ti, Ta, Cr, Mn, Zr, Cu, puis une autre couche de diélectrique tel SnO₂ éventuellement remplacée par du film organo-silicié également déposé sous plasma.

15. Substrat en verre selon la revendication 13, **caractérisé en ce que** les couches minces comprennent un film organo-silicé déposé sous plasma, une couche (5) de métal tel Ag, éventuellement de l'Al ou un métal appartenant au groupe Al, Ti, Ta, Cr, Mn, Zr, Cu, une épaisseur d'organo-silicié polymérisé sous plasma, cette épaisseur d'organo-silicié et le film de revêtement également en organosilicié pouvant éventuellement être déposés en une seule opération.

## Claims

1. Method of depositing, in a vacuum enclosure (1), a thin film by plasma-CVD onto a conducting substrate which serves as electrode for creating the discharge, characterized in that the substrate (4) is of insulating material in the form of a plate or sheet covered with a thin conducting film (5) and in that the alternating current causing said discharge is established between the thin conducting film (5), by at least one suitable electrical supply lead (13; 21), and the vacuum enclosure (1).

2. Method according to Claim 1, characterized in that the distance separating any point at which the deposition is carried out and the nearest electrical supply lead is less than or of the order of 180 cm, notably approximately 160 cm.

3. Method according to one of the preceding Claims, characterized in that the alternating current causing the discharge is supplied on at least one of the sides of the conducting substrate (4, 5).

4. Method according to Claim 3, characterized in that the alternating current causing the discharge is supplied on the two opposite sides of the conducting substrate (4, 5).

5. Method according to one of the preceding Claims, characterized in that the frequency of the current is less than 1 MHz, notably lies between 10 and 400 kHz.

6. Method according to one of the preceding Claims, characterized in that the film deposited by CVD-plasma is an organosiliceous film.

7. Method according to Claim 6, characterized in that the deposition is made in the presence of oxygen.

8. Method according to Claim 7, characterized in that the oxygen is provided by nitrogen protoxide.

9. Method according to one of the preceding Claims, characterized in that the reactive gas is supplied through the vacuum enclosure (1), which is the electrode not formed by the conducting substrate (4, 5).

10. Device for carrying out the method according to one of the preceding Claims, characterized in that it comprises a vacuum enclosure (1), at least one metal supply lead (13; 21) intended to be in close contact with the conducting substrate (4, 5) to be coated and an alternating voltage source (9), said source establishing the alternating current necessary for the discharge between the conducting substrate (4, 5) and the vacuum enclosure (1) by supplying said substrate through the electrical supply lead or leads (13; 21).

11. Device according to Claim 10, characterized in that the supply lead or leads (13; 21) are disposed on at least one of the edges of the conducting substrate (4, 5), the lead or leads being, with the exception of their contact surface with the conducting substrate (4, 5), entirely enclosed in an insulating material (14).

12. Device according to Claim 10 or 11, characterized in that it comprises one or more inlets (6) for reactive gas in the vacuum enclosure (1).

13. Insulating material substrate (4), notably of glass, coated with a conducting film, notably of glass coated with thin films, at least one (5) of which is conducting, such as of metal, notably silver, comprising, in addition, a coating of the organosiliceous coating type, deposited by a plasma-CVD technique, characterized in that, over a width of at least 3.60 m, the variation in thickness of said coating film is not greater than 10%.

14. Insulating material substrate (4), notably of glass, according to Claim 13, characterized in that the thin films comprise a film of dielectric such as SnO₂ directly in contact with the substrate (4), then a film of metal such as Ag (5), then optionally a film of Al or a metal belonging to the group Al, Ti, Ta, Cr, Mn, Zr, Cu, then another film of dielectric such as SnO₂, possibly replaced by an organosiliceous film, also deposited under plasma.

15. Glass substrate according to Claim 13, characterized in that the thin films comprise an organosiliceous film deposited under plasma, a film (5) of metal such as Ag, possibly of Al or of a metal belonging to the group Al, Ti, Ta, Cr, Mn, Zr, Cu, an organosiliceous thickness polymerized under plasma, this organosiliceous thickness and the coating film also of organosiliceous material being possibly deposited in one single operation.

## Patentansprüche

1. Verfahren zum Auftragen einer dünnen Schicht durch Plasma-CVD auf ein elektrisch leitfähiges Substrat, das als Entladungselektrode dient, im Inneren einer Vakuumkammer (1), **dadurch gekennzeichnet, dass** das Substrat (4) aus einer Platte oder Folie aus einem isolierenden Material besteht, das mit einer dünnen, elektrisch leitfähigen Schicht (5) bedeckt ist, **und dass** der die Entladung hervorrufende Wechselstrom zwischen der dünnen, leitfähigen Schicht, durch wenigstens eine geeignete Stromzuführung (13; 21), und der Vakuumkammer (1) angelegt wird.

2. Verfahren nach Anspruch 1, **dadurch gekennzeichnet, dass** der Abstand zwischen einer beliebigen Stelle, an der der Auftrag erfolgt, und der Stromzuführung weniger als 180 cm, insbesondere ungefähr 160 cm beträgt.

3. Verfahren nach einem der vorhergehenden Ansprüche, **dadurch gekennzeichnet, dass** der die Entladung hervorrufende Wechselstrom auf wenigstens einer der Seiten des leitfähigen Substrats (4, 5) zugeführt wird.

4. Verfahren nach Anspruch 3, **dadurch gekennzeichnet, dass** der die Entladung hervorrufende Wechselstrom auf zwei gegenüberliegenden Seiten des leitfähigen Substrats (4, 5) zugeführt wird.

5. Verfahren nach einem der vorhergehenden Ansprüche, **dadurch gekennzeichnet, dass** die Frequenz des Wechselstroms weniger als 1 MHz und insbesondere zwischen 10 und 400 kHz beträgt.

6. Verfahren nach einem der vorhergehenden Ansprüche, **dadurch gekennzeichnet, dass** die durch ein Plasma-CVD aufgetragene Schicht eine Organosiliziumschicht ist.

7. Verfahren nach Anspruch 6, **dadurch gekennzeichnet, dass** der Auftrag in Anwesenheit von Sauerstoff erfolgt.

8. Verfahren nach Anspruch 7, **dadurch gekennzeichnet, dass** der Sauerstoff durch Di-Stickstoff-Monoxid zugeführt wird.

9. Verfahren nach einem der vorhergehenden Ansprüche, **dadurch gekennzeichnet, dass** das reaktive Gas durch die Vakuumkammer (1) zugeführt wird, die die Gegenelektrode zum elektrisch leitfähigen Substrat (4, 5) bildet.

10. Vorrichtung zur Durchführung des Verfahrens nach einem der vorhergehenden Ansprüche, **dadurch gekennzeichnet, dass** sie eine Vakuum-Kammer (1), mindestens eine metallische Stromzuführung (13; 21) für einen engen Kontakt mit dem leitfähigen, zu beschichtenden Substrat (4, 5) und eine Wechselspannungsquelle (9) zum Anlegen des für die Entladung zwischen dem leitfähigen Substrat (4, 5) und der Vakuum-Kammer (1) notwendigen Stroms durch eine (oder mehrere) Stromzuführung(en) (13; 21) aufweist.

11. Vorrichtung nach Anspruch 10, **dadurch gekennzeichnet, dass** eine (mehrere) Stromzuführung(en) (13; 21) auf wenigstens einer Seite des leitfähigen Substrats (4, 5) angeordnet ist (sind) und mit Ausnahme ihrer Kontaktfläche mit dem leitfähigen Substrat (4, 5) vollständig von einem isolierenden Material (14) umgeben ist (sind).

12. Vorrichtung nach Anspruch 10 oder 11, **dadurch gekennzeichnet, dass** die Vakuumkammer (1) eine oder mehrere Zuführungen (6) für ein reaktives Gas aufweist.

13. Substrat aus einem isolierenden Material (4), inbesondere aus Glas, bedeckt mit einer leitfähigen Schicht, insbesondere aus mit dünnen Schichten bedecktem Glas, von denen wenigstens eine Schicht (5) leitfähig ist, beispielsweise aus einem Metall, insbesondere Silber, wobei das Substrat ausserdem eine durch ein Plasma-CVD-Verfahren aufgetragene Beschichtung aus einer Organosiliziumverbindung aufweist, **dadurch gekennzeichnet, dass** über eine Länge von mindestens 3,60 m die Dicke der Beschichtung um nicht mehr als 10 % variiert.

14. Substrat aus einem isolierenden Material (4), insbesondere Glas, nach Anspruch 13, **dadurch gekennzeichnet, dass** die dünnen Schichten eine dielektrische Schicht wie SnO₂ enthalten, die sich im direkten Kontakt mit dem Substrat (4) befindet, mit einer Schicht (5) aus einem Metall wie Silber darauf, darauf gegebenenfalls eine weitere Schicht, die Al, oder ein Metall der Gruppe Al, Ti, Ta, Cr, Mn, Zr, Cu enthält, darauf eine weitere dielektrische Schicht wie SnO₂, die gegebenenfalls durch einen gleichermassen unter einem Plasma aufgetragenen Organosilizidfilm ersetzt ist.

15. Substrat aus Glas nach Anspruch 13, **dadurch gekennzeichnet, dass** die dünnen Schichten einen unter einem Plasma aufgetragenen Organosilizidfilm, eine Schicht (5) aus einem Metall wie Silber, die gegebenenfalls Al oder ein Metall der Gruppe Al, Ti, Ta, Cr, Mn, Zr, Cu enthält, eine unter einem Plasma aufgetragene Organosilizidschicht aufweisen, wobei die Organosilizidschicht und ein Schutzfilm gegebenenfalls in einem Arbeitsgang aufgetragen sind.
